# FASCICULE DE BREVET EUROPEEN

(11) **EP 0 889 329 B1**
(45) Date de publication et mention de la délivrance du brevet: **19.09.2001**
(21) Numéro de dépôt: 98201927.5
(22) Date de dépôt: 09.06.1998
(51) Int. Cl.: G01R 1/36, G01R 11/04

(54) **Compteur d'électricité muni d'un système de protection contre les surtensions**
Elektrizitätszähler mit Überspannungsschutz
Electricity meter comprising a system for excess voltage protection

(30) Priorité: 01.07.1997 FR 9708388
(43) Date de publication de la demande: 07.01.1999
(73) Titulaire: Schlumberger Industries S.A., 92542 Montrouge Cedex (FR)
(72) Inventeur: Hamard, Guillaume, 75014 Paris (FR)

(56) Documents cités:
- FR-A- 1 105 108
- US-A- 5 282 108
- US-A- 5 572 396

## Description

La présente invention concerne un compteur d'électricité comprenant au minimum un conducteur de phase et un cavalier de neutre, les entrées et les sorties respectives du conducteur de phase et du cavalier de neutre étant déposées dans le boîtier du compteur parallèles les unes aux autres et coplanaires.

Cette disposition des conducteurs de phase et du neutre dans le boîtier est typique des compteurs d'électricité réalisés, par exemple, pour le marché européen. Une brusque variation de courant dans le réseau peut engendrer une surtension au niveau de l'une des phases. Si cette surtension est suffisamment élevée, l'air environnant s'ionise, devient conducteur et un arc électrique apparaît entre une phase et le neutre. L'énergie très élevée de cet arc, entretenu par le réseau de distribution électrique, échauffe l'air et peut provoquer l'explosion du boîtier. Ce risque est d'autant plus grand que le volume d'air chauffé est important.

Dans des compteurs conventionnels, le problème d'une surtension sur une phase est souvent géré par l'utilisation d'une varistance entre la phase et le neutre, placée à l'entrée du compteur pour protéger les circuits électroniques du compteur. La varistance est normalement non-conductrice au-dessous d'un seuil de tension prédéterminé. Dans le cas d'une tension au-dessus du seuil, la varistance deviendra conductrice et la surtension sera prise par le neutre.

Un exemple d'un autre système de protection de ce type est montré dans le brevet US 5282108. L'entrée de chaque phase est branchée, via un câble, à une électrode disposée immédiatement au-dessus d'une plaque métallique liée à la terre via une résistance en forme de bloc. Dans le cas d'une surtension, un courant entre l'électrode et la plaque sera conduit à la masse via la résistance.

Le but principal de ce système de protection est de protéger les composants électroniques contre les effets des surtensions. Le circuit de connexion entre une phase et la terre (un câble, une paire d'électrodes, une résistance) est relativement complexe. Dans le cas d'une faute dans l'un de ces composants, le compteur n'aura aucune protection contre une grande variation de courant et un arc pourra se créer.

De la même façon, dans les circuits de protections munis d'une ou de plusieurs varistances, le vieillissement des varistances peut rendre le circuit inactif et une surtension violente peut engendrer un arc entre une phase et le neutre, ou même entre deux phases avec les conséquences décrites ci-dessus.

Ainsi, l'un des objets de la présente invention est de surmonter les problèmes associés aux dispositifs connus afin de fournir un système de protection qui empêche la création d'un arc non-contrôlé, même dans le cas d'une défaillance du circuit de protection contre les surtensions normalement présent dans le compteur.

Un compteur d'électricité selon la présente invention se caractérise par une barre métallique connectée au neutre et disposée dans le boîtier du compteur immédiatement à proximité de l'entrée et/ou la sortie du conducteur de phase de manière à définir un espace dans lequel un arc contrôlé entre le conducteur de phase et la barre métallique peut se propager dans le cas d'une surtension.

Ainsi, en cas de défaillance (ou même de l'absence) d'un autre circuit de protection, la présente invention empêche la formation d'un arc non-contrôlé entre la ou les phases et le neutre dans le boîtier. La faible distance entre les phases et la barre du neutre fait que le volume d'air chauffé par l'arc contrôlé est insuffisant pour provoquer une explosion.

Dans un mode de réalisation, la présente invention s'applique à un compteur d'électricité comprenant plusieurs conducteurs de phase et un cavalier de neutre, les entrées et les sorties des conducteurs de phase et du neutre étant parallèles les unes aux autres et coplanaires, la longueur de la barre étant déterminée afin que les entrées et /ou les sorties de la totalité des conducteurs de phase se trouvent en vis-à-vis direct de la barre. La présente invention s'applique notamment à un compteur triphasé, muni de trois phases et un neutre.

La présente invention peut s'appliquer aux compteurs monophasé, c'est-à-dire des compteurs possédant un seul conducteur de phase ayant son entrée et sa sortie de chaque côté du cavalier de neutre. Cependant, le risque d'une explosion à cause d'un arc non contrôlé est plus élevée dans le cas d'un compteur multiphase, puisque la disposition de plusieurs phases et le neutre en parallèle dans le boîtier fait qu'il y a au moins une phase relativement éloignée du neutre. Un arc entre cette phase et le neutre sera ainsi beaucoup plus important que l'arc qui pourra être invoqué dans un compteur monophasé. Il peut y avoir également le problème d'arcs entre les phases voisines dans des compteurs triphasés.

La forme précise et exacte de la barre qui couvre les conducteurs de phase peut varier ; elle pourra être courbe, ou tout simplement droite en forme de "L". On choisira de préférence une forme améliorée d'une barre en forme de "L", caractérisée par des parties saillantes qui descendent à une distance très proche de chacune des phases et dont les bases sont courbes afin de s'adapter à la forme cylindrique des conducteurs de phase.

La barre reliée au neutre est placée de préférence dans le boîtier perpendiculairement au-dessus des phases et de la base du boîtier. D'autres réalisations sont également envisageables, par exemple, avec la barre de neutre disposée en dessous des phases dans le boîtier.

La barre peut être branchée au neutre du réseau via une connexion à un cavalier de neutre formé séparément de la barre de neutre. Cependant, dans un mode de réalisation préféré, la barre et le cavalier de neutre du compteur sont formés d'une seule pièce métallique. Cette solution évite le problème d'une mauvaise connexion entre l'écrêteur et le neutre et réduit le coût du dispositif.

Dans un mode de réalisation, le matériau choisi pour la barre est du cuivre. Ce matériau est très résistant aux effets d'un arc et peut porter un courant élevé pour une durée de temps relativement longue.

La présente invention peut s'appliquer à des compteurs sans autres moyens de protection contre des surtensions. Cependant, de préférence, le compteur se compose également d'une ou plusieurs varistances branchées entre l'entrée de chaque conducteur de phase et le neutre.

L'utilisation d'une série de varistances à l'entrée du compteur protège les circuits du compteur contre les effets d'une surtension sur le réseau. Le fonctionnement des deux systèmes de protection est plutôt complémentaire et le système de protection de l'invention sera utilisé seulement dans le cas d'une défaillance des varistances ou d'une surtension trop élevée pour être absorbée par les varistances. Tandis qu'il est possible de remplacer le système conventionnel par une barre à l'entrée du compteur très proche des conducteurs de phase pour absorber chaque petite surtension par la création d'arc contrôlé entre la phase et la barre, une telle utilisation serait peu appropriée étant donné qu'il est toujours préférable d'éviter la création d'un arc dans le boîtier.

De préférence, la barre est disposée en proximité et à une distance faible de la sortie de chaque conducteur de phase du compteur.

D'autres modes de réalisations sont possibles, par exemple, dans lesquels la barre s'étend au-dessus des conducteurs de phases à leur entrée dans le compteur ou au-dessus de l'entrée et la sortie de chaque conducteur. Cependant, comme on l'a décrit ci-dessus, il est préférable que le système de l'invention soit utilisé seulement dans le cas d'une défaillance du circuit de protection normale. La disposition de la barre à l'entrée du compteur augmente le risque que le système de l'invention fonctionne avant ou en même temps que les varistances dans un tel circuit.

L'invention sera mieux comprise à la lecture de la description qui suit d'un mode de réalisation de l'invention, donné à titre d'exemple illustratif et non limitatif et faisant références aux dessins annexés sur lesquels :
Fig. 1 est le schéma électrique équivalent d'un compteur triphasé muni d'un système de protection selon l'invention ;
Fig. 2 montre la sortie des conducteurs de phase d'un compteur triphasé où se situe une barre reliée au neutre selon le système de l'invention ;
Fig. 3 montre la barre de la figure 2 en détail ;
Fig. 4 montre une forme améliorée de la barre de la figure 3 ;

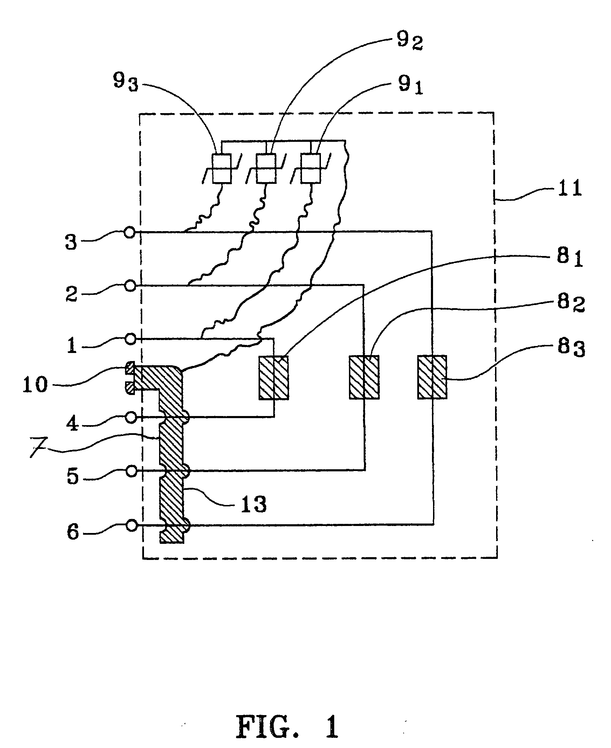

Le compteur dont le schéma électrique est fourni par la figure 1 est un compteur de type triphasé. Il est relié au réseau par les entrées des trois conducteurs de phase 1, 2, 3, au circuit utilisateur par les sorties des trois conducteurs de phase 4, 5, 6 et au neutre par un cavalier de neutre 10. Ce cavalier de neutre 10 se prolonge d'une barre 13 pour ne former qu'une seule pièce 7. Les trois conducteurs d'entrée 1, 2, 3 sont coplanaires et arrivent parallèlement dans le boîtier 11; de même les trois conducteurs de sortie 4, 5, 6 sont coplanaires et parallèles. Le comptage de puissance se fait à partir des capteurs de courant 8₁, 8₂, 8₃ connectés à chacune des phases entre le réseau et l'utilisateur. Le compteur comprend également des capteurs de tension et des circuits électriques pour calculer la puissance. Ces composants sont standards et ne seront pas décrits en détail. Trois varistances 9₁, 9₂, 9₃ reliées chacune entre une phase et le neutre constituent un premier système de sécurité en cas de surtension. En effet, une surtension éventuelle sur l'une des phases sera normalement évacuée vers le neutre par la varistance correspondante qui sera devenue conductrice si la valeur de la surtension est supérieure à sa tension-seuil.

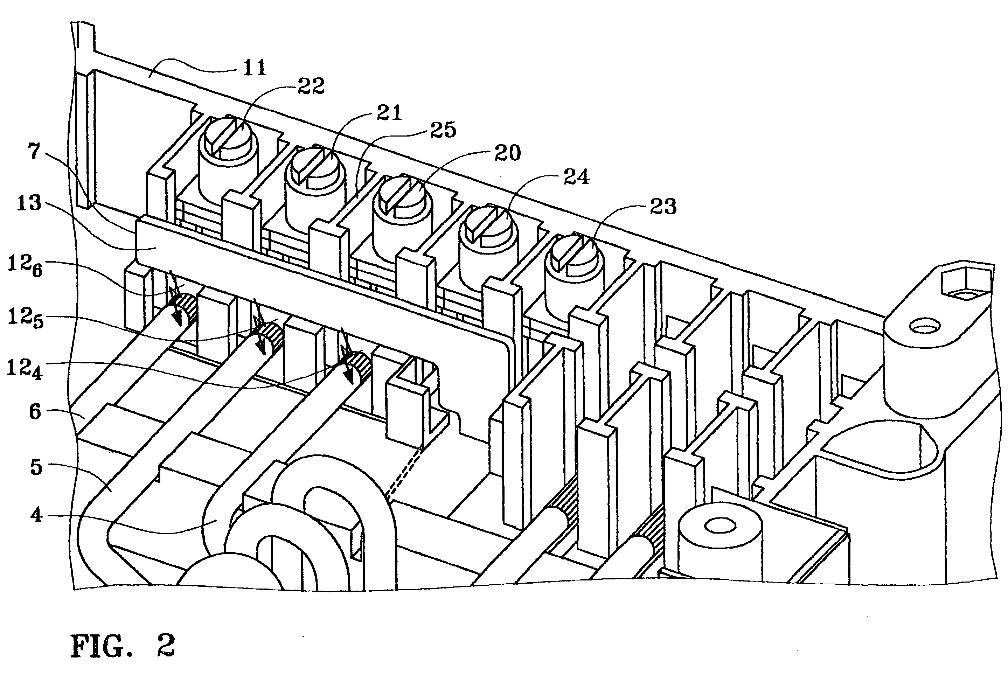

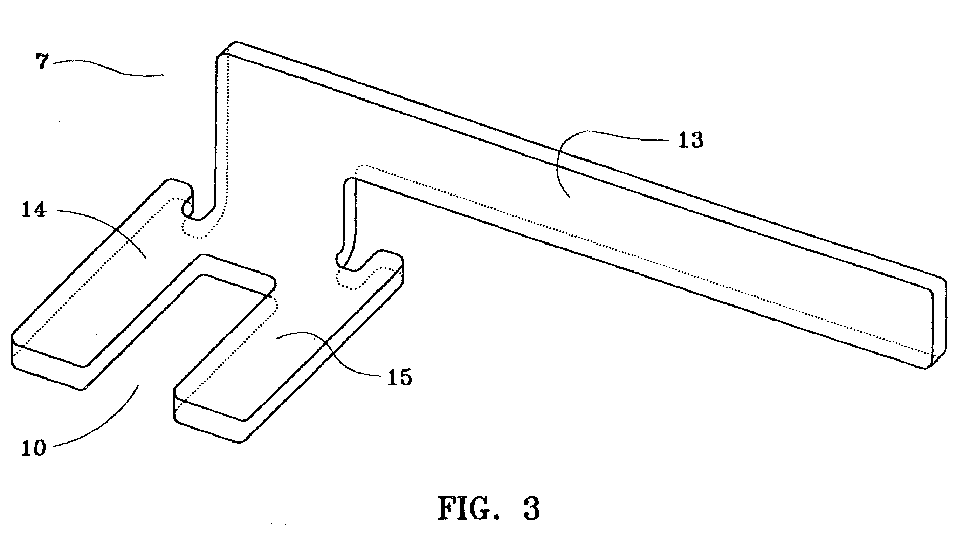

La figure 2 montre en détail les conducteurs de phase 4, 5, 6 et la pièce 7 reliée au neutre. Une vue générale de cette pièce 7 est fournie par la figure 3 sur laquelle on voit que cette pièce 7 se compose d'une barre 13 en forme de "L" et d'un cavalier de neutre 10 en forme de "U". La barre 13, comme le montre la figure 2, surmonte directement les trois conducteurs de phase 4, 5, 6. Plus précisément elle est placée perpendiculairement au-dessus des trois conducteurs de phase et de conducteurs. Des espaces interstitiels de faibles dimensions 12₄, 12₅, 12₆ sont ainsi crées entre la barre 13 et chaque conducteur de phase.

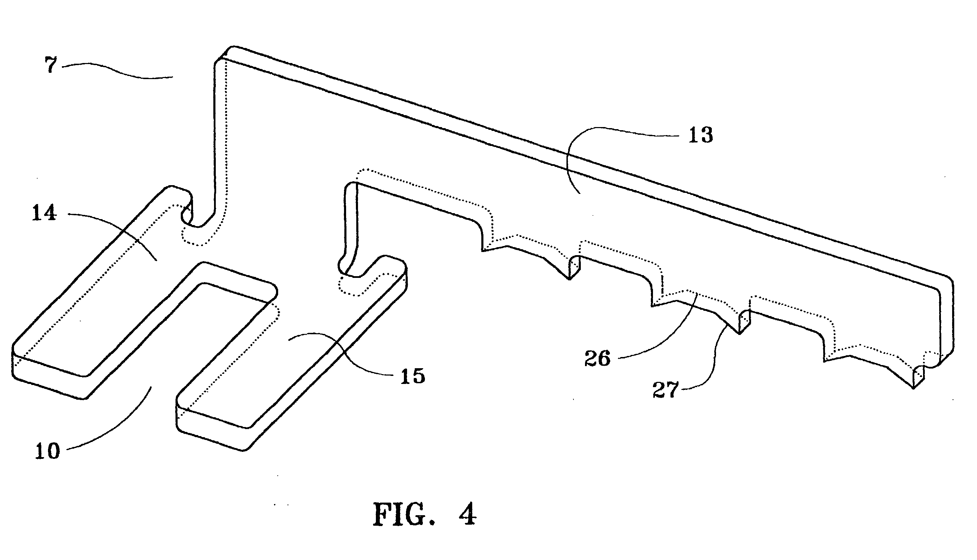

La figure 4 montre une forme améliorée de la barre 13 présentée en figure 3. En effet, la barre 13 est dotée de parties saillantes 26 qui descendent à une distance très proche de chaque conducteur de phase 4, 5, 6. Les bases 27 de ces parties 26 sont taillées courbes de façon à s'adapter le mieux possible à la forme cylindrique des conducteurs de phase.

Le premier système de sécurité constitué par les varistances et décrit ci-dessus est parfois défaillant ; les varistances vieillissent et deviennent alors inefficaces pour la gestion des surtensions. Le système formé par l'ensemble des trois conducteurs de phase et de la pièce 7 reliée au neutre constitue un système de protection complémentaire contre les surtensions. En cas de défaillance d'une varistance et dans la présence d'une surtension potentiellement dangereuse, l'air de l'espace 12₄, 12₅ ou 12₆ s'ionise, devient conducteur et un arc électrique contrôlé apparaît entre la phase 4, 5 ou 6 et la barre 13 reliée au neutre.

Typiquement, l'installation électrique dans laquelle le compteur est placé comprend une série de fusibles en amont du compteur qui permettent lors de courants importants d'ouvrir le circuit et de couper le courant. Le courant de l'arc qui circule dans le circuit entre une phase 4, 5, 6 et la barre de neutre 13 sera normalement suffisant pour ouvrir les fusibles et couper le courant. Par ces moyens, la présente invention permet au compteur de gérer un arc formé entre les phases et le neutre sans risquer l'explosion du boîtier jusqu'à ce que des éléments de sécurité en dehors du compteur réagissent pour couper le courant au compteur.

La connexion de la pièce 7 au neutre est assurée par sa partie terminale constituée de deux pattes plates 14 et 15 qui définissent le cavalier de neutre 10. Ce contact est garantit par les deux vis 23, 24 qui maintiennent serrés les deux pattes 14, 15 et les conducteurs de neutre du circuit utilisateur. La connexion entre les trois conducteurs de sortie 4, 5, 6 et les trois phases du circuit utilisateur se fait par l'intermédiaire des trois vis 20, 21, 22. Toutes ces connexions sont à l'extérieur du boîtier 11 et sont isolées entre elles par les partitions 25 du boîtier 11. L'écrêteur, c'est-à-dire les conducteurs de phase 4, 5, 6 et la barre 13, se trouve à l'intérieur du boîtier 11.

## Revendications

1. Un compteur d'électricité comprenant au minimum un conducteur de phase et un cavalier de neutre (10), les entrées (1, 2, 3) et les sorties (4, 5, 6) respectives du conducteur de phase et du cavalier de neutre (10) étant déposées dans le boîtier (11) du compteur parallèles les unes aux autres et coplanaires, **caractérisé par** une barre métallique (13) connectée au neutre et disposée dans le boîtier (11) du compteur immédiatement à proximité de l'entrée (1, 2, 3) et/ou la sortie (4, 5, 6) du conducteur de phase de manière à définir un espace dans lequel un arc contrôlé entre le conducteur de phase et la barre métallique (13) peut se propager dans le cas d'une surtension.

2. Un compteur d'électricité selon la revendication 1 comprenant plusieurs conducteurs de phase et un cavalier de neutre (10), les entrées (1, 2, 3) et les sorties (4, 5, 6) des conducteurs de phase et du neutre étant parallèles les unes aux autres et coplanaires, la longueur de la barre étant déterminée afin que les entrées (1, 2, 3) et /ou les sorties (4, 5, 6) de la totalité des conducteurs de phase se trouvent en vis-à-vis direct de la barre (13).

3. Un compteur d'électricité selon la revendication 1 ou 2 dans lequel la barre (13) qui couvre les conducteurs de phase est en forme de "L".

4. Un compteur d'électricité selon la revendication 3 dans lequel la barre (13) qui couvre les conducteurs de phase en forme de "L" est **caractérisée par** des parties saillantes (26) qui descendent à une distance très proche de chacune des phases et dont les bases (27) sont courbes afin de s'adapter à la forme cylindrique des conducteurs de phase.

5. Un compteur d'électricité selon l'une quelconque des revendications 1 à 4 dans lequel la barre (13) est placée dans le boîtier (11) perpendiculairement au-dessus des phases et de la base du boîtier.

6. Un compteur d'électricité selon l'une quelconque des revendications 1 à 5, dans lequel la barre (13) et le cavalier de neutre (10) du compteur sont formés d'une seule pièce métallique (7).

7. Un compteur d'électricité selon l'une quelconque des revendications 1 à 6 dans lequel le matériau choisi pour la barre (13) est du cuivre.

8. Un compteur d'électricité selon l'une quelconque des revendications 1 à 7, dans lequel le compteur se compose également d'une ou plusieurs varistances (9₁, 9₂, 9₃) branchées entre l'entrée (1, 2, 3) de chaque conducteur de phase et le neutre.

9. Un compteur d'électricité selon l'une quelconque des revendications 1 à 8, dans lequel la barre (13) est disposée immédiatement à proximité de la sortie (4, 5, 6) de chaque conducteur de phase du compteur.

## Patentansprüche

1. Elektrizitätszähler, der wenigstens einen Phasenleiter und eine Nulleiterbrücke (10) umfaßt, wobei die Eingänge (1, 2, 3) und die Ausgänge (4, 5, 6) des Phasenleiters und der Nulleiterbrücke (10) in einem Gehäuse (11) des Zählers parallel zueinander und koplanar angeordnet sind, **gekennzeichnet durch** einen Metallstab (13), der mit dem Nulleiter verbunden ist und im Gehäuse (11) des Zählers direkt neben dem Eingang (1, 2, 3) und/oder dem Ausgang (4, 5, 6) des Phasenleiters in der Weise angeordnet ist, daß ein Raum definiert wird, in dem sich bei einer Überspannung zwischen dem Phasenleiter und dem Metallstab (13) ein kontrollierter Lichtbogen ausbreiten kann.

2. Elektrizitätszähler nach Anspruch 1, mit mehreren Phasenleitern und einer Nulleitungsbrücke (10), wobei die Eingänge (1, 2, 3) und die Ausgänge (4, 5, 6) der Phasenleiter und des Nulleiters zueinander parallel und koplanar sind, wobei die Länge des Stabs so bestimmt ist, daß sich die Eingänge (1, 2, 3) und/oder die Ausgänge (4, 5, 6) aller Phasenleiter direkt gegenüber dem Stab (13) befinden.

3. Elektrizitätszähler nach Anspruch 1 oder 2, in dem der Stab (13), der die Phasenleiter abdeckt, die Form eines "L" hat.

4. Elektrizitätszähler nach Anspruch 3, in dem der Stab (13), der die Phasenleiter in Form eines "L" bedeckt, gekennzeichnet ist durch vorstehende Teile (26), die bis zu einem sehr geringen Abstand zu jeder der Phasen herabhängen und deren Grundflächen (27) gekrümmt sind, um sich an die zylindrische Form der Phasenleiter anzupassen.

5. Elektrizitätszähler nach einem der Ansprüche 1 bis 4, in dem der Stab (13) im Gehäuse (11) senkrecht oberhalb der Phasen und der Grundfläche des Gehäuses angeordnet ist.

6. Elektrizitätszähler nach einem der Ansprüche 1 bis 5, in dem der Stab (13) und die Nulleiterbrücke (10) des Zählers aus einem einzigen Metallteil (7) gebildet sind.

7. Elektrizitätszähler nach einem der Ansprüche 1 bis 6, in dem das für den Stab (13) gewählte Material Kupfer ist.

8. Elektrizitätszähler nach einem der Ansprüche 1 bis 7, in dem der Zähler außerdem aus einem oder mehreren Varistoren (9₁, 9₂, 9₃) aufgebaut ist, die zwischen den Eingang (1, 2, 3) jedes Phasenleiters und den Nulleiter geschaltet sind.

9. Elektrizitätszähler nach einem der Ansprüche 1 bis 8, in dem der Stab (13) direkt neben dem Ausgang (4, 5, 6) jedes Phasenleiters des Zählers angeordnet ist.

## Claims

1. An electricity meter comprising at least one phase conductor and a neutral jumper (10), the respective inputs (1, 2, 3) and outputs (4, 5, 6) of the phase conductor and neutral jumper (10) being arranged within the meter housing (11) parallel and coplanar to each other, **characterized by** a metal bar (10) connected to the neutral wire and arranged within the meter housing (11) adjacent to the input (1, 2, 3) and/or the output (4, 5, 6) of the phase conductor so as to define a space within which a controlled arcing between the phase conductor and the metal bar (13) can propagate in case of an overvoltage.

2. An electricity meter according to claim 1, comprising several phase conductors and one neutral jumper (10), the inputs (1, 2, 3) and outputs (4, 5, 6) of the phase and neutral conductors being parallel and coplanar to each other, the bar length being determined so that the inputs (1, 2, 3) and/or outputs (4, 5, 6) of all the phase conductors are placed directly in front of the bar (13).

3. An electricity meter according to claim 1 or 2, wherein the bar (13) which overlies the phase conductors is "L"-shaped.

4. An electricity meter according to claim 3, wherein the bar (13) which overlies the "L"-shaped conductors is **characterized by** protruding portions (26) which extend downwards to a very small distance from each of the phase conductors and have curved bases (27) in order to match the cylindrical shape of the phase conductors.

5. An electricity meter according to any of claims 1 to 4, wherein the bar (13) is placed in the housing (11) perpendicular and above the phase conductors and the housing base.

6. An electricity meter according to any of claims 1 to 5, wherein the bar (13) and the neutral jumper (10) of the meter are formed of only one metal piece (7).

7. An electricity meter according to any of claims 1 to 6, wherein the material chosen for the bar (13) is copper.

8. An electricity meter according to any of claims 1 to 7, wherein the counter is also composed of one or several varistors (9₁, 9₂, 9₃) connected between the input (1, 2, 3) of each phase conductor and the neutral wire.

9. An electricity meter according to any of claims 1 to 8, wherein the bar (13) is arranged adjacent to the output (4, 5, 6) of each of the meter's phase conductors.
